# EUROPEAN PATENT SPECIFICATION

(11) **EP 2 128 633 B1**
(45) Date of publication and mention of the grant of the patent: **02.05.2012**
(21) Application number: 08009850.2
(22) Date of filing: 29.05.2008
(51) Int. Cl.: G01R 19/00, G01R 19/25

(54) **Current-sense amplifier arrangement and method for measuring a voltage signal**
Strommessungsverstärkeranordnung und Verfahren zur Messung eines Spannungssignals
Agencement d'amplificateur de détection de courant et procédé de mesure d'un signal de tension

(43) Date of publication of application: 02.12.2009
(73) Proprietor: Austriamicrosystems AG, 8141 Unterpremstätten (AT)
(72) Inventor: Tiruvuru, Rajesh, 517589 Andhra Pradesh (IN); Brandl, Manfred, 8112 Gratwein (AT); Ele, Vijay, Dadar 400014 Mumbai (IN)
(74) Representative: Epping - Hermann - Fischer

(56) References cited:
- WO-A-03/049282
- US-A1- 2005 046 480
- US-A1- 2005 179 573
- US-A1- 2006 244 521
- US-B1- 7 295 061
- WITTE J F ET AL: "A Current-Feedback Instrumentation Amplifier with 5 V Offset for Bidirectional High-Side Current-Sensing" SOLID-STATE CIRCUITS CONFERENCE, 2008. ISSCC 2008. DIGEST OF TECHNICAL PAPERS. IEEE INTERNATIONAL, IEEE, PISCATAWAY, NJ, USA, 3 February 2008 (2008-02-03), pages 74-75, XP031253554 ISBN: 978-1-4244-2010-0
- DAMIEN MCCARTNEY ET AL: "A Low-Noise Low-Drift Transducer ADC" IEEE JOURNAL OF SOLID-STATE CIRCUITS, IEEE SERVICE CENTER, PISCATAWAY, NJ, US, vol. 32, no. 7, 1 July 1997 (1997-07-01), pages 959-967, XP011060511 ISSN: 0018-9200

## Description

The present invention relates to a current-sense amplifier arrangement as well as a method for measuring a current or voltage signal.

Recent applications in industrial and automotive fields often require precise measuring of current or voltage signals. Such results may then be used to calculate the actual supply voltage provided by a voltage source or the amount of current drawn by a device connected to a source. For instance, a precise measurement of a voltage provided by a battery source as well as the current drawn by the loads may be required in automotive applications.

Document US 5,498,984 presents a current-sense amplifier typically used to measure an amount of current drawn from or supplied to a power supply in various types of electronic equipments. The amount of current can then be used to calculate an actual voltage value of the battery source. Document US 6,621,259 shows another circuit for measuring a bi-directional current across a current-sense element.

The documents Wiite J.F. et al. "A Current-Feedback Instrumentation Amplifier with with 5V Offset for Bi-directional High-Side Current-Sensing", Solid-State Circuits Conference, 2008. ISSCC 2008. Digest of Technical Papers. IEEE International, IEEE, Piscataway, NJ, USA, 2008-02-03, pages 74-75, XP031253554 ISBN: 978-1-4244-2010-0 illustrates an amplifier with high and low-side stages. Reference McCartney, Damien et al: "A Low-Noise Low-Drift Transducer ADC", IEEE Journal of Solid-State Circuits, IEEE Service Center, Piscataway, NJ, US, Vol. 32, No. 7, 1997-07-01, pages 959-967, XP011060511 ISSN 0018-9200 shows an arrangement for signal sensing.

Document US 2005/0046480 A1 relates to an improved common mode feedback circuit for fully differential two-stage operational amplifiers.

Those documents teach a sense amplifier which, however, may have limited capabilities in respect to high-precision application measurements. For instance, the output signal may comprise an offset and/or low-frequency noise generated in the sense amplifier itself.

Therefore, it is preferable to come up with an improved current-sense amplifier arrangement as well as a method for measuring a current or voltage signal.

These and other objects are solved by the subject matter of the present independent claims. Further embodiments and advantages are subject to the dependent claims.

The present invention proposes, inter alia, improving the measurement by chopping a signal derived by a current flowing through a current-voltage converter. The chopped signal could be then amplified using a fully differential amplifier with a common mode feedback network to provide an amplified and chopped output signal. The amplified output signal is then converted into a digital signal and digitally dechopped afterwards.

Further, the invention proposes a technique for implementing a common mode level translation in a fully differential fashion and with chopper stabilization for decreasing an offset and low-frequency noise of the amplification circuit. Such proposal will also allow implementing the chopper as well as part of the amplifier in a first voltage domain using a supply voltage derived by a voltage source coupled to the current-voltage converter. The analog-to-digital conversion as well as the digital dechopper may be implemented in a second voltage domain using, for instance, standard CMOS technology.

Such separation between two different voltage domains seems to be useful if high supply voltages or currents have to be processed. Further, such separation allows using already existing analog-to-digital converters.

In an embodiment, a current-sense amplifier arrangement may comprise a current-voltage converter to provide a differential voltage signal, that voltage signal derived by a current flowing through the converter. A chopper circuit is coupled to the converter to receive the differential voltage. The chopper circuit chops the differential voltage responsive to a chopping frequency and provides a chopped differential output signal. Said output signal is provided to a fully differential amplifier.

The amplifier comprises a common mode feedback network to maintain the common mode voltage compatible with an analog-to-digital converter coupled downstream to the differential amplifier. The differential amplifier may also comprise a high-side input stage and a low-side output stage. The high-side input stage is coupled with a signal input to the chopper circuit and with a feedback input to the low-side output stage.

The amplifier provides a well defined common mode output voltage signal. The output stage is connected to the analog-to-digital converter which is coupled upstream to a digital dechopper. The digital dechopper dechops the digital values provided by the converter in response to a signal with a chopping frequency, that chopping frequency depending on the chopping frequency of the chopper circuit.

In another embodiment, a current-sense amplifier arrangement may comprise a resistor, said resistor coupled to a first voltage source. A feedback differential amplifier is adapted to receive a chopped differential voltage derived by a current flowing through the resistor. A differential amplifier comprises a first amplifier stage, said first amplifier stage being supplied by a first voltage source and a second amplifier stage, said second amplifier stage being supplied by a second voltage source. The second amplifier stage is adapted to receive a differential signal provided by the first stage and provides an output signal having a common mode voltage. A dechopper is coupled to an output of the second stage of the feedback differential amplifier, said dechopper supplied by a voltage derived by the second voltage source.

In a further embodiment, a current-sense amplifier arrangement comprises a fully differential amplifier. The fully differential amplifier further comprises a double differential input circuit to separate a feedback path from a signal input path thereby achieving almost infinite input impedance. The feedback path is coupled to an output of the differential amplifier and comprises a controllable current source to provide a selectable current to the feedback input. The current source is also coupled to two different loads with a selectable resistance. The first load is arranged between the current source, the feedback input and the output of the amplifier stage while the second load is arranged between the feedback input and a terminal, on which a common mode reference voltage signal is applied.

In an embodiment, the current-voltage converter for providing a differential voltage derived by the current flowing through the converter comprises a resistor with a low resistance. In an embodiment, the resistance is in the range of 100 µΩ.

In a further embodiment, the resistor comprises manganin or a similar component developing a very low thermoelectric voltage connected to copper track for signal routing to measurement device input terminals.

The chopper may comprise a plurality of switching transistors in each signal path as well a level shifter to improve control the switching of the transistors. It may be useful, if each signal path comprises a first and a second transistor connected in series, wherein the second transistor is shorted. In such case a differential control signal can be applied at the first and second transistors, wherein the shorted switching transistor serves the purpose of a dummy switch working on a complementary clock for cancelling the charge injection and clock feed-through of the first switching transistor.

The gate of each transistor may be coupled to a current mirror circuit, whose mirror transistors provide the required switching signal. The mirror transistors are controlled by the switching clock signal. The gate of the switching transistors may be also coupled to the first voltage source providing the high voltage.

In a method according to the present invention, a differential voltage is chopped using a signal with a chopping frequency, thereby converting a DC differential voltage into an AC similar signal. The differential voltage is derived by converting a current to be sensed into a differential voltage signal. The chopped differential voltage is then amplified and converted into a digital signal. A digital signal is a signal comprising time-discrete discrete values. The digital signal is then dechopped using the chopping frequency.

Further embodiments and several aspects will be come apparent for those skilled in the art in connection with the explanation and the accompanying drawings in which
- FIG. 1: shows a first embodiment of a high-precision high- side current measurement setup,
- FIG. 2: shows an embodiment for a high-precision high-side current measurement setup in greater detail,
- FIG. 3: shows an embodiment of a two-stage amplifier used in the previous embodiments,
- FIG. 4: shows an embodiment of an analog chopper to provide a chopped differential voltage signal,
- FIG. 5: shows a diagram of the clock signals used in the chopper according to the embodiment of FIG. 4 over time,
- FIG. 6: shows an embodiment for a clock generation circuit used to generate respective clock signals for the chopper.

Functionally or operatively similar components may have the same reference symbols in the embodiments provided herein.

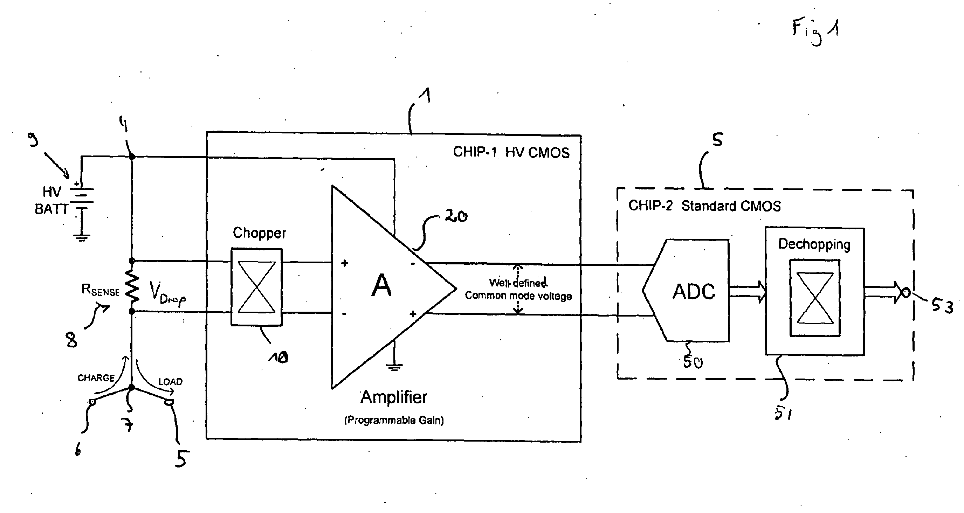

FIG. 1 depicts an embodiment of a high-precision high-side current measurement setup for high-voltage batteries. Such high-precision measurements may be required in several industrial and/or automotive applications. For instance, a high-voltage battery providing a voltage in the range up to 40 V is used in a car, supplying drive control circuits, safety devices and all driver applications with the electrical power. For cost saving purposes, it may now be necessary to provide a precise measurement of the supply voltage provided by the battery depending on any load connected thereto as well as the actual charging or decharging battery current.

For this purpose, a high-voltage battery 9 considered as the first voltage source is coupled via a first node 4 to a measurement resistor 8, also named Rₛₑₙₛₑ. A charge current is flowing via nodes 6 and 7 through resistor 8 to charge the high voltage battery 9. Accordingly, a load current is flowing to node 5 through the measurement resistor 8 as indicated.

The actual current flowing through the measurement resistor, regardless whether it is a charging or a load current, is given by the voltage drop V_{Drop} across the measurement resistor 8 and the value of the resistor.

The voltage drop V_{Drop} being a differential voltage is applied to a first high-voltage CMOS amplifier arrangement 1, being implemented in a first semiconductor body. The amplifier arrangement 1 comprises a first two-stage amplifier 20 with a programmable gain having a high impedance input and a well defined common mode voltage output. The amplifier is implemented in a high-voltage CMOS technology, wherein the amplifier is capable of, on the one hand, being supplied with a high supply voltage and at the same time capable of processing low differential voltage signals.

This way, a programmable gain amplifier can be combined with a level translation to facilitate the measurement different currents in several ranges. For this purpose, the signal input of the amplifier 20 is connected to a chopping device 10, the chopping device 10 adapted to receive the differential voltage across the measurement resistor. The chopping device 10 chops the differential DC voltage and provides a differential AC similar voltage to the amplifier 20. The chopping device as well as the later explained dechopping device 51 is used to remove offset and low-frequency noise generated in the amplifier or the high-voltage or low-voltage domain during signal processing.

The amplifier 20 amplifies the chopped signal and provides an output signal with a well defined common mode voltage suitable for an analog-to-digital converter 50 being part of a second semiconductor body 5. The circuits implemented in the second semiconductor body 5 are realized in a standard CMOS technology using a second supply voltage. The analog-to-digital converter 50 converts the well defined common mode voltage signal into digital values and a digital signal, respectively. However, due to the chopping device 10 the digital output values are still chopped. To provide the desired output value representing the current through the resistor 8, a dechopping device 51 is connected downstream. The dechopping device 51 receives the digital values and uses the chopping frequency to dechop the chopped digital signal. Hence, the dechopped signal is re-merged, resulting in a precise digital value of the differential voltage measured across the resistor 8.

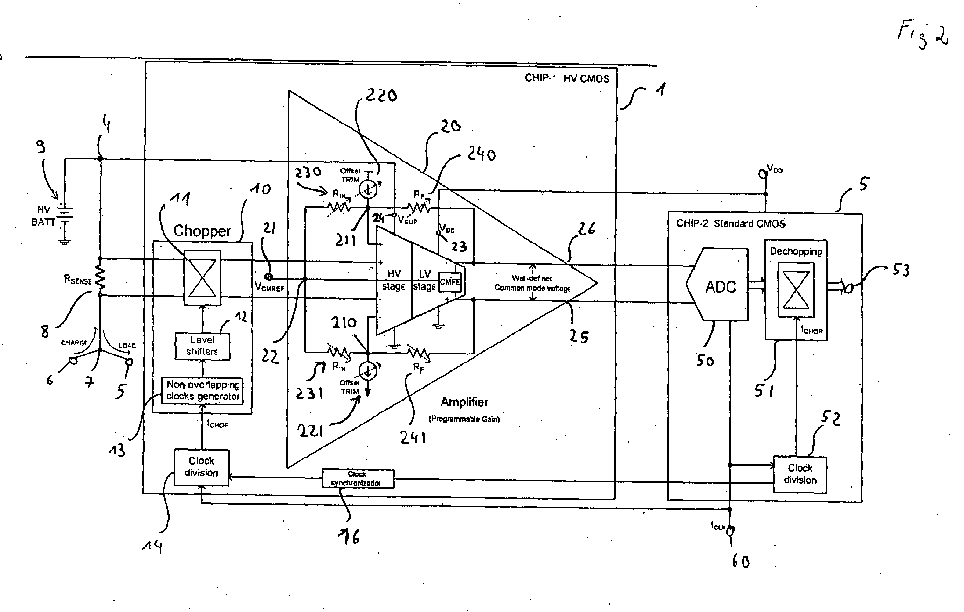

FIG. 2 shows a further embodiment of a high-precision high-side current measurement setup. The high-voltage battery 9 supplies the amplifier circuit 20 and the chopping device 10 within the first semiconductor body 1.

In the embodiment, the amplifier 20 comprises two stages. The first stage, a fully differential high-voltage stage is supplied by the high-voltage battery 9 via terminal 24. The high-voltage stage HV receives the differential chopped input signal as well as a differential feedback signal. For this purpose, the feedback input terminals of the high-voltage stage HV are connected to a first node 210 and a second node 211, respectively. The first node 210 is coupled to a first current source 221 for trimming any offset current, which will later be explained in greater detail. The first node 210 is also coupled to a first resistor 231 and to a second resistor 241. The second feedback node 211 is connected to a second current source 220, a first and a second resistor 230, 240. Each resistor 230, 231, 240 and 241 comprise a selectable resistance.

The first resistors 231, 230 are connected to a common node 21, on which a common mode reference signal is applied to. The common mode reference signal is used in the second amplifier stage to set the common mode voltage of the amplifier's output signal. The second resistors 241, 240 are coupled to the respective output terminals of a second amplifier stage LV. The second amplifier stage LV is considered as a low-side amplifier stage and coupled to a second voltage supply terminal V_{DD}. The second supply voltage applied thereto may be smaller than the voltage provided by the high-voltage battery 9. The second amplifier stage receives an amplified signal from the first amplifier stage HV and provides a well defined common mode output voltage signal.

The output terminals 24 and 26 of amplifier 20 and the second amplifier stage LV are connected to the input terminals of the analog-to-digital converter 50 in a second semiconductor 5 implemented in standard CMOS technology. The circuitry arranged in the second semiconductor body is supplied by voltage V_{DD} as well. The analog-to-digital converter 50 generates a digital value out of the amplified chopped signal and provides that digital value to a dechopping device 51. The dechopping device 51 uses a chopping frequency clock signal to dechop the chopped signal and provides the corresponding digital value at output terminal 53. The chopping frequency clock signal is generated by a first clock division circuit 52, wherein the clock division circuit receives a common clock signal at terminal 60 as well as a synchronization control signal by the clock synchronizer 16.

A second clock division circuit 40 is implemented in the first semiconductor body 1 to provide a control signal with the same chopping frequency f_{chop}. For correct dechopping in device 51, an exact synchronization of both chopping frequency clock signals with frequency f_{chop} are required. For this purpose, the clock synchronizer 16 generates synchronization signals for both clock division circuits 14 and 52, thereby ensuring a specific phase shift between both control signals of the clock division circuits 14 and 52.

The chopper device 10 comprises a non-overlapping clock generator 13 connected to the clock division circuit 14. The clock generator 13 provides clock signals to a level shifter 12 to generate the corresponding switching signals for the switching device 11 in chopper 10. The switching device 11 receives the differential voltage from the resistor element 8 and provides a chopped differential voltage to the input terminals of the first amplifier stage of amplifier 20.

In the embodiment, the level translation circuit is implemented as a fully differential feedback amplifier with a common mode feedback network to maintain the common mode voltage compatible with the analog-to-digital converter. The amplifier is chosen to comprise a double differential input circuit to separate the feedback path from an input path, thereby achieving infinite input impedance. Due to the infinite input impedance, the resistance changes of the chopping device 10 do not significantly influence the amplification characteristics of amplifier 20.

A programmable gain can be achieved by changing the resistance value of the selectable resistors 230, 240, 231, 241 in the feedback path. Any offset in the amplifier stages can be compensated by injecting into or removing from the feedback nodes 210, 211 the appropriate amount of currents using the feedback current sources 220, 221.

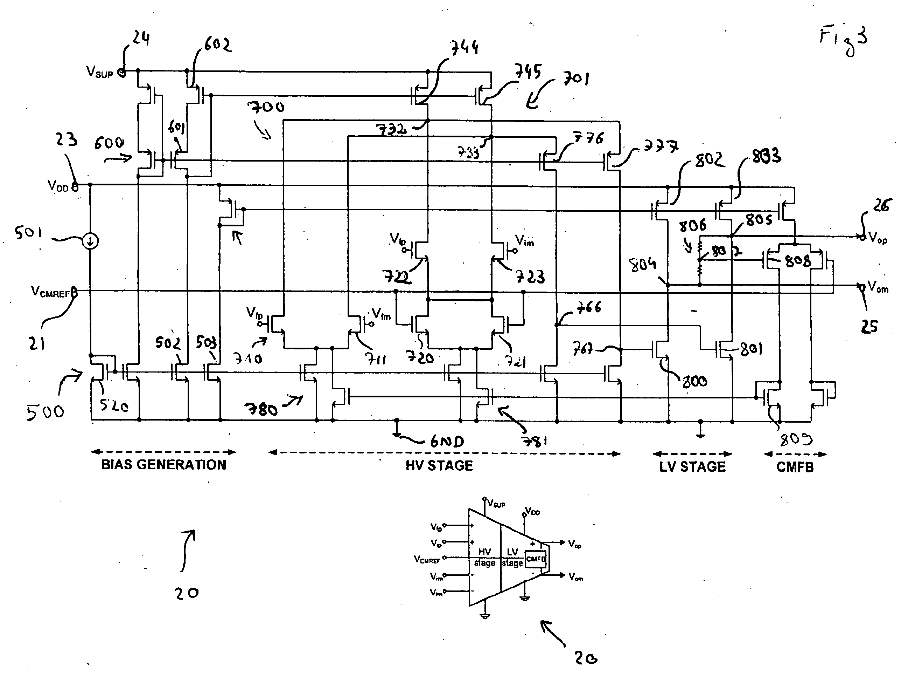

FIG. 3 shows an embodiment of the fully differential feedback amplifier with all implemented amplifier stages. The amplifier comprises a bias generation circuitry BIAS GENERATION, a high-voltage amplifier stage HV STAGE, a low-voltage amplifier stage LV STAGE as well as a common mode feedback circuit CMFB. While the high-voltage amplifier stage is coupled to terminal 24 for being supplied by voltage V_{SUP} provided by the high-voltage battery supply, the low-voltage amplifier stage is coupled to terminal 23, on which the second supply voltage VDD is applied to.

The bias generation circuit comprises a first current mirror circuit 500, whose mirror transistor 520 is connected to a constant current source 501 coupled to the second voltage supply terminal 23. The current mirror 500 mirrors the current into the respective current sources of the high-voltage amplifier stage, thereby adjusting the BIAS current through the differential amplifier of this stage. The bias current of the LV and the CMFB stage is adjusted as well.

A second current mirror 600 is coupled with its current mirror transistor and a second transistor connected in series between the first voltage supply terminal 24 and a transistor being part of the first current mirror 500. The current of second current mirror 600 is mirrored into output transistors 776, 777 of the high-voltage amplifier stage and to a transistor 601 arranged between transistor 502 being part of the first current mirror 500 and transistor 602 being the current mirror transistor of the further current mirror comprising transistors 602, 744 and 745.

Transistors 744, 745 are coupled to the first voltage supply terminal 24 and connected with their second terminals to common nodes 732 and 733, respectively. The common nodes 732, 733 are considered output nodes of a first differential amplifier 700 and a second differential amplifier 701. The first differential amplifier 700 comprises two amplifier transistors 710, 711 having a common node coupled to a current source 780. The current source 780 comprises a transistor coupled to the first current mirror 500 to provide the BIAS current as mentioned above. At the gate terminals of the respective amplifier transistors 710, 711 of the first differential amplifier 700, the differential feedback signal is applied to.

Accordingly, the feedback path is separated within the high-voltage amplifier stage from the input path, which is implemented in the second differential amplifier stage 701. The second differential amplifier stage also comprises two amplifier transistors 722, 721, their input terminals forming the respective signal input to receive the differential chopped voltage Vᵢₚ, Vᵢₘ. Further, the second differential amplifier stage 701 comprises a common mode circuit with transistors 720, 721, a common node of both transistors coupled to current source 781 for BIAS current adjustment. Transistor 720 is connected with its drain terminal to transistor 722 as well as to transistor 723. Accordingly, transistor 721 of the common mode circuit is coupled with its drain terminal to amplifier transistors 722 and 723, respectively. The current source 781 comprises a transistor connected to a current mirror 500.

The common output nodes 732, 733 are further coupled to output transistors 776 and 777, respectively. The output nodes are arranged between transistors 776 and 777 and two other transistors providing the BIAS current and connected with their gate terminals to the first current mirror 500.

The output nodes 766 and 767 of the high-voltage stage provide an amplified output signal to an emitter follower implemented in the low-voltage stage LV STAGE. Each follower circuit comprises a transistor pair 800, 802 and 801, 803 of the different types arranged between the second voltage supply terminal 23 and the ground terminal GND. Output nodes 804 between the first transistor pair 800, 802 is connected to the first output terminal 25 of the amplifier 20. Accordingly, output node 805 arranged between the second transistor pair is coupled to the second output terminal 26. In addition, a resistor ladder 806 comprising two resistors is arranged between output nodes 804, 805. A node 807 between two resistors of ladder 806 is connected to transistor 808 of a differential amplifier implementing the common mode feedback. The differential amplifier is arranged between the second voltage supply terminal 23 and the ground terminal GND. A second amplifier path of the differential amplifier is connected to terminal 21 to receive the common mode reference voltage signal.

The current mirror transistor 809 is arranged in a first path of the differential amplifier, and particularly connected to the first transistor 808. The current mirror transistor 809 mirrors the common mode current into the current sources 781, 780 of the first and second differential amplifier stage of the first high-side stage LV STAGE. In the second path of the differential amplifier of the common mode feedback stage, the transistor is connected with its gate terminal directly to its drain terminal. The common mode feedback due to the current mirror transistor 809 allows accommodating the battery voltage in its input common mode range.

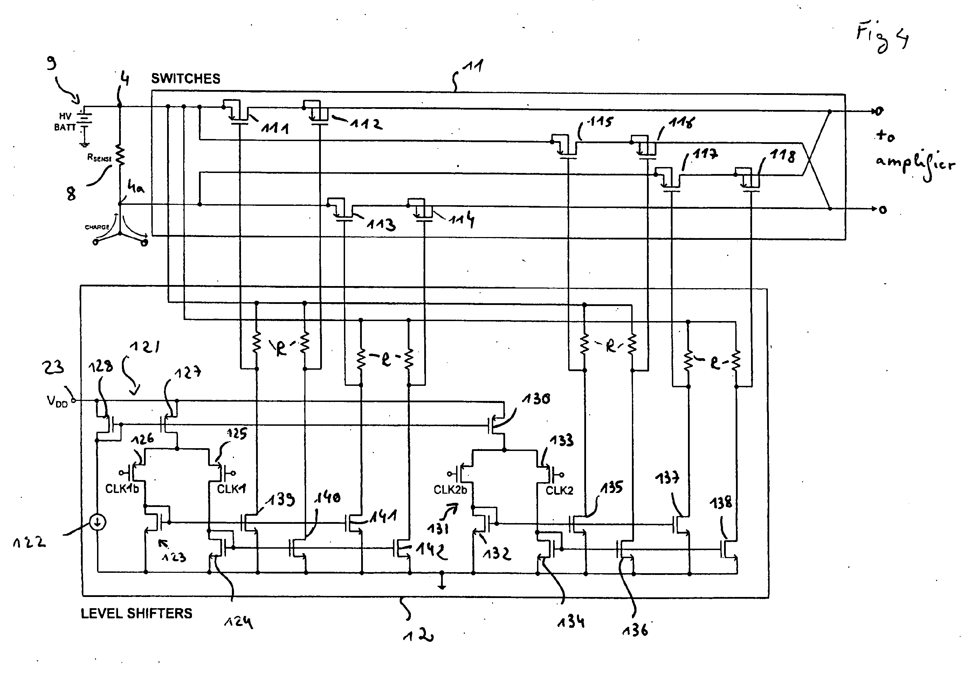

FIG. 4 shows an embodiment of the switching device 11 and the level shifter 12, both being part of the chopping device 10. The switching device 11 comprises a plurality of transistors 111 to 118. Particularly, a first pair of transistors 111, 112 is arranged in a first path between node 4 on the input side and an output node to the amplifier. A transistor pair 113, 114 is arranged in series between node 4a and the respective output node of the switching device 11 to the amplifier.

A third and a fourth pair of switching transistors 115 to 118 is connected in a switching path cross-coupling the input nodes 4, 4a to the respective output nodes of switching device 11. In the embodiment, the second transistors 112, 114, 116 and 118 of each transistor pair is shorted to provide a dummy switch. As a result, the switch with the switching transistor is always shorted irrespective of its gate clock level. As it will be explained in greater detail below, the dummy switches are controlled by a complimentary clock provided by the level shifter 12. The complimentary clock may cancel any charge injection and clock feed-through of the first switches in each transistor pair, resulting in a more precise measurement.

The level shifter 12 is supplied by the second supply voltage V_{DD} at terminal 23. The level shifter comprises two differential circuits on which differential clock signals CLK, CLKB are applied. The differential circuits are coupled to the second voltage terminal 23 via transistor 127 and transistor 130, respectively. Both transistors 127, 130 are connected with their respective gate terminals to a current mirror transistor 128 arranged in series with a constant current source 122 between ground terminal GND and the second supply voltage terminal 23. The current mirror 121 provides a constant current to both clock circuits for generating the respective switching signals.

Each differential circuit comprises a series circuit of a first transistor 125, 126, 131 and 133 and a respective current mirror transistor 123, 124, 132 and 134. Particularly, transistor 126 is arranged in series with current mirror transistor 123, and transistor 125 is arranged in series to current mirror transistor 124. The current mirror transistors are of different transistors types with respect to transistors 125, 126, 131 and 133.

Each current mirror transistor 123, 124 and 132, 134 mirrors its current to a source follower transistor 134 to 142 arranged between the ground terminal and a respective resistor R. The other terminal of each resistor R is connected to the first voltage supply and particularly to the high-voltage battery 9.

Between each resistor R and the respective source follower transistors 135 to 142, a node is provided, that node connected to the respective gate terminals of the switching transistors in switching device 11.

In the embodiment, the second current mirror transistor 124 of the first clock circuit is connected to the gate terminals of transistors 140, 142 which are controlling the gates of the shorted transistors 112, 114 of the respective transistor pairs. Accordingly, transistors 136, 138 coupled to current mirror transistor 134 of the second clock circuit provide control of shorted transistors 116, 118 of the third and fourth transistor pair. This feature results in the above-mentioned complimentary clock provided at each shorted transistor pair during operation of the level shifter.

In other words, if, for instance, transistors 139, 141 of the first clock circuit are switched on, the respective other transistors 140, 142 are switched of due to the differential clock signals CLK1 and CLK1b. Transistors 135 to 138 are controlled accordingly.

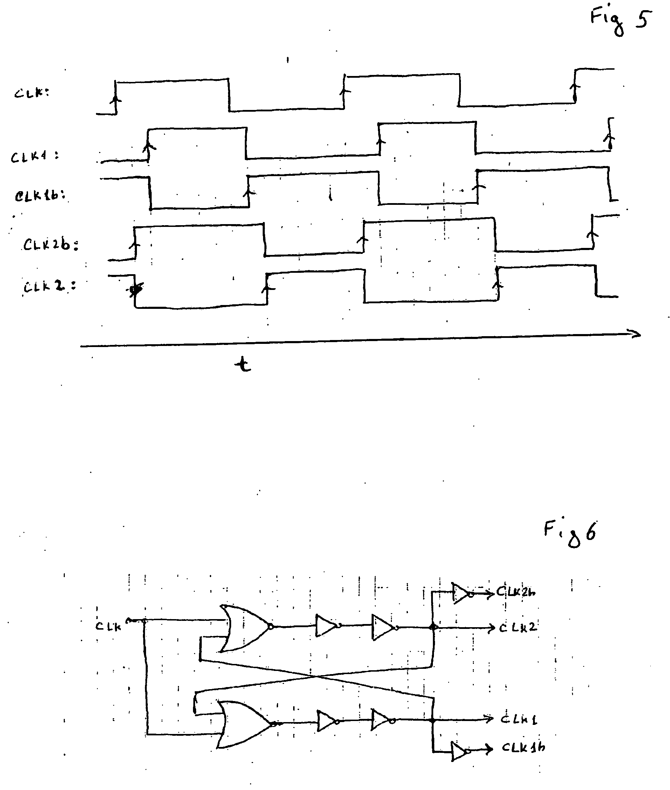

FIG. 5 shows a clock time diagram to visualize the operation of the level shifter 12 and the switching device 11. Both clock signals CLK1, CLK2 are derived from a general common clock CLK. The common clock CLK includes the chopping frequency f_{chop} and is applied to the non-overlapping clock generator 13 according to the embodiment of Figure 2. The clock generator 13 generates two differential clock signals CLK1, CLK1b and CLK2, CLK2b, respectively. As shown in the time diagram according to FIG 5, the duty cycles of both differential clock signals CLK1, CLK2 are different. For instance, the "OFF-state" wherein the signal level is LOW in the duty cycle of clock signals CLK1, CLK2 is longer than the respective "ON-state" of both signals, wherein signal level is HIGH. Accordingly, the differential clock signals CLK1b, CLK2b each comprise a longer "ON-state" in their respective duty cycles.

The clock signal CLK1, CLK2 are both used in operation of the level shifter according to FIG 4 to generate the signal controlling the shorted transistors 112, 114 and 116, 118, respectively. The differential clock signals CLK1b, CLK2b are generating the respective control signals for the switching transistors arranged in the switching device 11. Due to the different duty cycle of both clock signals CLK1, CLK2, both clock signals are overlapping during transition from LOW to HIGH and vice versa. The overlapping time span of both clock signals is chosen to be adjusted to the switching behavior of the switching transistor 111, 113, 115 and 117 of the switching device 11. As a result, chopping the input signal from the sense resistor 8 becomes smoother and any noise due to the switching is reduced.

Figure 6 shows an embodiment of a non-overlapping clock generator 13 to generate the above-mentioned clock signals. The clock generator 13 comprises an input terminal on which the common clock signal CLK is applied. In a first path of the clock generator a NOR gate and two inverter circuits are arranged in series to generate a first clock signal CLK1. The first clock signal CLK1 is also applied to a further inverter to generate the inverted clock signal CLK1b.

In a second path, an additional series circuit of a NOR gate and two inverters connected downstream are arranged to generate the second clock CLK2. The output node of the second path is also connected to a further inverter to generate the inverted second clock signal CLK2b. The output nodes of the first and second path of the clock are connected to the respective other input terminals of the second and first path to implement a feedback of the clock generator. Depending on the desired duty cycle of the first and second clock CLK1, CLK2 the delay chain comprising the two inverters in each path has to be adjusted by adding additional inverters or adjusting the delay time of each inverter in the signal paths. The inverter used to generate the inverted clock signals CLK1b, CLK2b should comprise a fast transition behavior to reduce any delay in the transition between the respective clock signal and the inverted clock signal.

## Claims

1. A current sense amplifier arrangement, comprising:
- a current-voltage converter (8) for providing a differential voltage derived by a current flowing through the converter;
- a fully differential amplifier (1) comprising a high-side input stage (HV stage) with a signal input terminal and a low-side output stage (LV stage);
- a chopper circuit (10, 11) coupled to the current voltage converter (8) for chopping the differential voltage responsive to a signal with a chopping frequency, an output of the chopper circuit (10, 11) coupled to the signal input terminal of the high-side input stage (HV stage);
- an analogue-to-digital converter (50) coupled to an output of the low-side output stage (LV stage) of the fully differential amplifier;
- a digital dechopper (51) coupled to the analogue to digital converter (50) for dechopping the digital values provided by the analogue to digital converter responsive to a signal with the chopping frequency,
**characterised in that** - the current sense amplifier arrangement comprises a first voltage source and a second voltage source;
- the fully differential amplifier (1) comprises a common mode feedback network and wherein the high-side input stage (HV stage) comprises a feedback input, which is coupled via the feedback network to the output of the low-side output stage (LV stage) to receive a feedback signal
wherein
- the current-voltage converter comprises a resistor (8), said resistor coupled to the first voltage source (9);
- wherein the high-side input stage comprises a first amplifier stage (HV stage), said first amplifier stage (HV Stage) and the chopper (10) being supplied by the first voltage source (9), said first voltage source coupled to the current-voltage converter (8) to provide the current flowing through the converter;
- wherein the low-side output stage comprises a second amplifier stage, said second amplifier stage being supplied by the second voltage source (23, Vdd) and adapted to receive a differential signal provided by the first stage and to provide an output signal having a common mode voltage,
wherein the analogue to digital converter is supplied by the second voltage source (23, Vdd).

2. The amplifier arrangement according to claim 1, wherein the chopper (10, 11) comprises a plurality of switching transistors (111 - 118) in the signal path and a level shifter to control a switching of the transistors (111 - 118), wherein the level shifter is adapted to generate switching signals derived by the first voltage and in response to a chopping signal having the chopping frequency.

3. The amplifier arrangement according to any of claims 1 to 2, wherein the high-side input stage (HV stage) comprises:
- a first differential amplifier circuit (700) connected with its input terminals to the feedback input;
- a second differential amplifier circuit (701) connected with its input terminals to the signal input;
- the first and second differential amplifiers both coupled to a common supply node (24), said node to receive a higher supply voltage than the low-side output stage and both coupled with their output terminals (766, 767) to an input of the low-side output stage.

4. The amplifier arrangement according to any of claims 1 to 3, wherein the low-side output stage comprises a common mode voltage generation circuit (CMFB) having a differential amplifier, to which a common mode reference signal is applied, the common mode voltage generation circuit coupled to the high-side input stage to control a current through the high-side input stage.

5. The amplifier arrangement according to any of claims 1 to 4, wherein the common mode feedback network comprises a controllable current source (220, 221) coupled to the feedback input of the high-side input stage and via a controllable load (240, 241) to an output of the low-side output stage.

6. The amplifier arrangement according to any of claims 1 to 5, wherein the chopper circuit (10, 11) and at least the high-side input stage (LV stage) of the amplifier are arranged in a first semiconductor body and at least the analogue-to-digital is arranged in a second semiconductor body.

7. The amplifier arrangement according to claim 1, wherein the first amplifier stage is adapted to receive a common mode feedback signal derived by at least the output signal of the second amplifier stage and a controllable current source.

8. The amplifier arrangement according to any of claims 1 to 7, wherein the first amplifier stage (HV stage) comprises a first differential amplifier (700) circuit to receive a common mode feedback signal and a second differential amplifier circuit (701) to receive the chopped differential voltage, the first and second differential amplifier coupled to the first voltage source.

9. The amplifier arrangement according to any of claims 1 to 7, wherein the second amplifier stage (LV stage) comprises a differential amplifier, adapted with a first terminal to receive the differential signal provided by the first stage and with a second terminal to receive a common mode reference signal, the differential amplifier adapted to provide a signal to control a current through the first amplifier stage.

10. The amplifier arrangement according to any of claims 1 to 7, wherein:
- the chopper circuit (10, 11) is arranged between the resistor (8) and the first amplifier stage (HV stage), said chopper adapted to provide the chopped differential voltage and comprising:
- a first and a second input (4, 4a);
- a first and a second output, said first and second output connected to the first amplifier stage;
- a first and a second selectable signal path, coupling the first and second input with the respective first and second output;
- a third selectable signal path, coupling the first input to the second output;
- a fourth selectable signal path, coupling the second input with the first output;
- wherein the first and second or the third and fourth signal paths are selected in response to a clock signal having a chopping frequency.

11. The amplifier arrangement according to claim 10, wherein each signal path comprise a switching transistor (111, 113, 115, 117) and a shortened dummy switching transistor (112, 116, 118, 114), wherein gates of the switching transistor and the shortened dummy switching transistor are coupled to the first voltage source in response to the clock signal.

## Patentansprüche

1. Strommessverstärkeranordnung, Folgendes umfassend:
- einen Strom/Spannungs-Wandler (8) zum Bereitstellen einer Differenzspannung, die sich von einem durch den Wandler fließenden Strom ableitet;
- einen Volldifferenzverstärker (1), der eine hochspannungsseitige Eingangsstufe (HV stage) mit einem Signaleingangsanschluss und eine niederspannungsseitige Ausgangsstufe (LV stage) umfasst;
- eine auf den Strom/Spannungs-Wandler (8) aufgeschaltete Zerhackerschaltung (10, 11) zum Zerhacken der Differenzspannung im Ansprechen auf ein Signal mit einer Zerhackfrequenz, wobei ein Ausgang der Zerhackerschaltung (10, 11) auf den Signaleingangsanschluss der hochspannungsseitigen Eingangsstufe (HV stage) aufgeschaltet ist;
- einen Analog/Digital-Wandler (50), der auf einen Ausgang der niederspannungsseitigen Ausgangsstufe (LV stage) des Volldifferenzverstärkers aufgeschaltet ist;
- einen auf den Analog/Digital-Wandler (50) aufgeschalteten digitalen Enthacker (51) zum Enthacken der durch den Analog/Digital-Wandler bereitgestellten digitalen Werte im Ansprechen auf ein Signal mit der Zerhackfrequenz, **dadurch gekennzeichnet dass**
- die Strommessverstärkeranordnung eine erste Spannungsquelle und eine zweite Spannungsquelle umfasst;
- der Volldifferenzverstärker (1) ein Gleichtaktrückkopplungsnetzwerk umfasst, und wobei die hochspannungsseitige Eingangsstufe (HV stage) einen Rückkopplungseingang umfasst, der über das Rückkopplungsnetzwerk auf den Ausgang der niederspannungsseitigen Ausgangsstufe (LV stage) aufgeschaltet ist, um ein Rückkopplungssignal zu empfangen, wobei
- der Strom/Spannungs-Wandler ein Widerstandselement (8) umfasst, wobei das Widerstandselement auf die erste Spannungsquelle (9) aufgeschaltet ist;
- wobei die hochspannungsseitige Eingangsstufe eine erste Verstärkerstufe (HV stage) umfasst, wobei die erste Verstärkerstufe (HV stage) und der Zerhacker (10) durch die erste Spannungsquelle (9) versorgt werden, wobei die erste Spannungsquelle auf den Strom/Spannungs-Wandler (8) aufgeschaltet ist, um den durch den Wandler fließenden Strom bereitzustellen;
- wobei die niederspannungsseitige Ausgangsstufe eine zweite Verstärkerstufe umfasst, wobei die zweite Verstärkerstufe durch die zweite Spannungsquelle (23, Vdd) versorgt wird und dazu angepasst ist, ein durch die erste Stufe bereitgestelltes Differenzsignal zu empfangen und ein Ausgangssignal mit einer Gleichtaktspannung bereitzustellen,
wobei der Analog/Digital-Wandler durch die zweite Spannungsquelle (23, Vdd) versorgt wird.

2. Verstärkeranordnung nach Anspruch 1, wobei der Zerhacker (10, 11) mehrere Schalttransistoren (111 - 118) im Signalpfad und einen Pegelverschieber umfasst, um einen Schaltvorgang der Transistoren (111 118) zu steuern, wobei der Pegelverschieber dazu angepasst ist, Schaltsignale, die sich von der ersten Spannung ableiten und im Ansprechen auf ein Zerhacksignal mit der Zerhackfrequenz zu erzeugen.

3. Verstärkeranordnung nach einem der Ansprüche 1 bis 2, wobei die hochspannungsseitige Eingangsstufe (HV stage) umfasst:
- eine erste Differenzverstärkerschaltung (700), die mit ihren Eingangsanschlüssen an den Rückkopplungseingang angeschlossen ist;
- eine zweite Differenzverstärkerschaltung (701), die mit ihren Eingangsanschlüssen an den Signaleingang angeschlossen ist;
- wobei der erste und zweite Differenzverstärker beide auf einen gemeinsamen Versorgungsknoten (24) aufgeschaltet sind, wobei der Knoten eine höhere Versorgungsspannung als die niederspannungsseitige Ausgangsstufe erhalten soll, und beide mit ihren Ausgangsanschlüssen (766, 767) auf einen Eingang der niederspannungsseitigen Ausgangsstufe aufgeschaltet sind.

4. Verstärkeranordnung nach einem der Ansprüche 1 bis 3, wobei die niederspannungsseitige Ausgangsstufe eine Gleichtaktspannungserzeugungsschaltung (CMFB) mit einem Differenzverstärker umfasst, an den ein Gleichtaktbezugssignal angelegt wird, wobei die Gleichtaktspannungserzeugungsschaltung auf die hochspannungsseitige Eingangsstufe aufgeschaltet ist, um einen durch die hochspannungsseitige Eingangsstufe fließenden Strom zu steuern.

5. Verstärkeranordnung nach einem der Ansprüche 1 bis 4, wobei das Gleichtaktrückkopplungsnetzwerk eine steuerbare Stromquelle (220, 221) umfasst, die auf den Rückkopplungseingang der hochspannungsseitigen Eingangsstufe und über eine steuerbare Last (240, 241) auf einen Ausgang der niederspannungsseitigen Ausgangsstufe aufgeschaltet ist.

6. Verstärkeranordnung nach einem der Ansprüche 1 bis 5, wobei die Zerhackerschaltung (10, 11) und zumindest die hochspannungsseitige Eingangsstufe (HV stage) des Verstärkers in einem ersten Halbleiterkörper angeordnet sind, und zumindest der Analog/Digital-Wandler in einem zweiten Halbleiterkörper angeordnet ist.

7. Verstärkeranordnung nach Anspruch 1, wobei die erste Verstärkerstufe dazu angepasst ist, ein Gleichtaktrückkopplungssignal zu empfangen, das sich zumindest vom Ausgangssignal der zweiten Verstärkerstufe und einer steuerbaren Stromquelle ableitet.

8. Verstärkeranordnung nach einem der Ansprüche 1 bis 7, wobei die erste Verstärkerstufe (HV stage) die erste Differenzverstärkerschaltung (700), um ein Gleichtaktrückkopplungssignal zu empfangen, und die zweite Differenzverstärkerschaltung (701) umfasst, um die zerhackte Differenzspannung zu empfangen, wobei der erste und zweite Differenzverstärker auf die erste Spannungsquelle aufgeschaltet sind.

9. Verstärkeranordnung nach einem der Ansprüche 1 bis 7, wobei die zweite Verstärkerstufe (LV stage) einen Differenzverstärker umfasst, der mit einem ersten Anschluss dazu angepasst ist, das durch die erste Stufe bereitgestellte Differenzsignal zu empfangen, und mit einem zweiten Anschluss, um ein Gleichtaktbezugssignal zu empfangen, wobei der Differenzverstärker dazu angepasst ist, ein Signal bereitzustellen, um einen durch die erste Verstärkerstufe fließenden Strom zu steuern.

10. Verstärkeranordnung nach einem der Ansprüche 1 bis 7, wobei:
- die Zerhackerschaltung (10, 11) zwischen dem Widerstandselement (8) und der ersten Verstärkerstufe (HV stage) angeordnet ist, wobei der Zerhacker dazu angepasst ist, die zerhackte Differenzspannung bereitzustellen und umfasst:
- einen ersten und einen zweiten Eingang (4, 4a);
- einen ersten und einen zweiten Ausgang, wobei der erste und zweite Ausgang an die erste Verstärkerstufe angeschlossen sind;
- einen ersten und einen zweiten wählbaren Signalpfad, der den ersten und zweiten Eingang mit dem jeweiligen ersten und zweiten Ausgang verbindet;
- einen dritten wählbaren Signalpfad, der den ersten Eingang mit dem zweiten Ausgang verbindet;
- einen vierten wählbaren Signalpfad, der den zweiten Eingang mit dem ersten Ausgang verbindet;
- wobei der erste und zweite oder der dritte und vierte Signalpfad im Ansprechen auf ein Taktsignal mit einer Zerhackfrequenz gewählt werden.

11. Verstärkeranordnung nach Anspruch 10, wobei jeder Signalpfad einen Schalttransistor (111, 113, 115, 117) und einen verkürzten Scheinschalttransistor (112, 116, 118, 114) umfasst, wobei Gates des Schalttransistors und des verkürzten Scheinschalttransistors im Ansprechen auf das Taktsignal auf die erste Spannungsquelle aufgeschaltet werden.

## Revendications

1. Dispositif amplificateur de sens de courant, comprenant:
- un convertisseur courant-tension (8) destiné à fournir une tension différentielle dérivée d'un courant traversant le convertisseur;
- un amplificateur entièrement différentiel (1) comprenant un étage d'entrée côté haut (HV stage) avec une borne d'entrée de signal et un étage de sortie côté bas (LV stage);
- un circuit hacheur (10, 11) couplé au convertisseur courant-tension (8), destiné à hacher la tension différentielle en réponse à un signal ayant une fréquence de hachage, une sortie du circuit hacheur (10, 11) étant couplée à la borne d'entrée de signal de l'étage d'entrée côté haut (HV stage);
- un convertisseur analogique-numérique (50) couplé à une sortie de l'étage de sortie côté bas (LV stage) de l'amplificateur entièrement différentiel;
- un déhacheur numérique (51) couplé au convertisseur analogique-numérique (50), destiné à déhacher les valeurs numériques fournies par le convertisseur analogique-numérique en réponse à un signal ayant la fréquence de hachage,
**caractérisé en ce que**
- le dispositif amplificateur de sens de courant comprend une première source de tension et une deuxième source de tension;
- l'amplificateur entièrement différentiel (1) comprend un réseau de retour en mode commun et où l'étage d'entrée côté haut (HV stage) comprend une entrée de retour, qui est couplée via le réseau de retour à la sortie de l'étage de sortie côté bas (LV stage) pour recevoir un signal de retour
où
- le convertisseur courant-tension comprend une résistance (8), ladite résistance étant couplée à la première source de tension (9);
- où l'étage d'entrée côté haut comprend un premier étage amplificateur (HV stage), ledit premier étage amplificateur (HV stage) et le hacheur (10) étant alimentés par la première source de tension (9), ladite première source de tension étant couplée au convertisseur courant-tension (8) pour fournir le courant traversant le convertisseur;
- où l'étage de sortie côté bas comprend un deuxième étage amplificateur, ledit deuxième étage amplificateur étant alimenté par la deuxième source de tension (23, Vdd) et apte à recevoir un signal différentiel fourni par le premier étage et à fournir un signal de sortie ayant une tension de mode commun,
où le convertisseur analogique-numérique est alimenté par la deuxième source de tension (23, Vdd).

2. Le dispositif amplificateur selon la revendication 1, où le hacheur (10, 11) comprend une pluralité de transistors de commutation (111 - 118) dans le chemin de signal et un commutateur de niveau pour commander une commutation des transistors (111 - 118), où le commutateur de niveau est apte à générer des signaux de commutation dérivés de la première tension et en réponse à un signal de hachage ayant la fréquence de hachage.

3. Le dispositif amplificateur selon l'une quelconque des revendications 1 à 2, où l'étage d'entrée côté haut (HV stage) comprend:
- un premier circuit amplificateur différentiel (700) connecté par ses bornes d'entrée à l'entrée de retour;
- un deuxième circuit amplificateur différentiel (701) connecté par ses bornes d'entrée à l'entrée de signal;
- les premier et deuxième amplificateurs différentiels étant tous deux couplés à un noeud d'alimentation (24) commun, ledit noeud étant prévu pour recevoir une tension d'alimentation supérieure à l'étage de sortie côté bas, et étant tous deux couplés par leurs bornes de sortie (766, 767) à une entrée de l'étage de sortie côté bas.

4. Le dispositif amplificateur selon l'une quelconque des revendications 1 à 3, où l'étage de sortie côté bas comprend un circuit de génération de tension en mode commun (CMFB) comportant un amplificateur différentiel, auquel un signal de référence en mode commun est appliqué, le circuit de génération de tension en mode commun étant couplé à l'étage d'entrée côté haut pour commander un courant traversant l'étage d'entrée côté haut.

5. Le dispositif amplificateur selon l'une quelconque des revendications 1 à 4, où le réseau de retour en mode commun comprend une source de courant (220, 221) pouvant être commandée, couplée à l'entrée de retour de l'étage d'entrée côté haut et, via une charge (240, 241) pouvant être commandée, à une sortie de l'étage de sortie côté bas.

6. Le dispositif amplificateur selon l'une quelconque des revendications 1 à 5, où le circuit hacheur (10, 11) et au moins l'étage d'entrée côté haut (HV stage) de l'amplificateur sont disposés dans un premier corps semiconducteur et au moins le convertisseur analogique-numérique est disposé dans un deuxième corps semiconducteur.

7. Le dispositif amplificateur selon la revendication 1, où le premier étage amplificateur est apte à recevoir un signal de retour en mode commun dérivé d'au moins le signal de sortie du deuxième étage amplificateur et d'une source de courant pouvant être commandée.

8. Le dispositif amplificateur selon l'une quelconque des revendications 1 à 7, où le premier étage amplificateur (HV stage) comprend le premier circuit amplificateur différentiel (700) pour recevoir un signal de retour en mode commun et le deuxième circuit amplificateur différentiel (701) pour recevoir la tension différentielle hachée, le premier et le deuxième amplificateur différentiel étant couplés à la première source de tension.

9. Le dispositif amplificateur selon l'une quelconque des revendications 1 à 7, où le deuxième étage amplificateur (LV stage) comprend un amplificateur différentiel, muni d'une première borne pour recevoir le signal différentiel fourni par le premier étage et d'une deuxième borne pour recevoir un signal de référence en mode commun, l'amplificateur différentiel étant apte à fournir un signal pour commander un courant traversant le premier étage amplificateur.

10. Le dispositif amplificateur selon l'une quelconque des revendications 1 à 7, où:
- le circuit hacheur (10, 11) est disposé entre la résistance (8) et le premier étage amplificateur (HV stage), ledit hacheur étant apte à fournir la tension différentielle hachée et comprenant:
- une première et une deuxième entrée (4, 4a);
- une première et une deuxième sortie, ladite première et ladite deuxième sortie étant connectées au premier étage amplificateur;
- un premier et un deuxième chemin de signal sélectionnable, couplant la première et la deuxième entrée à la première et la deuxième sortie respective;
- un troisième chemin de signal sélectionnable, couplant la première entrée à la deuxième sortie;
- un quatrième chemin de signal sélectionnable, couplant la deuxième entrée à la première sortie;
- où le premier et le deuxième ou bien le troisième et le quatrième chemin de signal sont sélectionnés en réponse à un signal d'horloge ayant une fréquence de hachage.

11. Le dispositif amplificateur selon la revendication 10, où chaque chemin de signal comprend un transistor de commutation (111, 113, 115, 117) et un transistor de commutation fictif raccourci (112, 116, 118, 114), où des portes du transistor de commutation et du transistor de commutation fictif raccourci sont couplées à la première source de tension en réponse au signal d'horloge.
